Europäisches Patentamt

European Patent Office

Office européen des brevets

(19)

(11) Numéro de publication: **0 194 916**
**B1**

(12) # FASCICULE DE BREVET EUROPEEN

(45) Date de publication du fascicule du brevet:
**17.05.89**

(51) Int. Cl.⁴: **H01L 21/265,** H01L 21/28,
H01L 21/82

(21) Numéro de dépôt: **86400403.1**

(22) Date de dépôt: **25.02.86**

(54) Procédé de fabrication de circuits intégrés en technologie MOS et CMOS, et structure CMOS correspondante.

(30) Priorité: **26.02.85 FR 8502769**

(43) Date de publication de la demande:
**17.09.86 Bulletin 86/38**

(45) Mention de la délivrance du brevet:
**17.05.89 Bulletin 89/20**

(84) Etats contractants désignés:
**AT CH DE FR GB IT LI NL**

(56) Documents cités:
**EP-A- 0 054 259**
**EP-A- 0 072 522**
**EP-A- 0 101 000**
**EP-A- 0 135 163**
**EP-A- 0 139 371**
**US-A- 4 280 271**
**US-A- 4 295 897**

**IEEE TRANSACTIONS ON ELECTRON DEVICES, vol. ED-30, no. 2, février 1983, pages 110-118, IEEE, New York, US; M. SUGINO et al.: "Latchup-free schottky-barrier CMOS"**

(73) Titulaire: **SGS-THOMSON MICROELECTRONICS S.A., 7, Avenue Galliéni, F-94250 Gentilly(FR)**

(72) Inventeur: **Monroy, Agustin, THOMSON-CSF SCPI 19, avenue de Messine, F-75008 Paris(FR)**
Inventeur: **Prudhomme, Danielle, THOMSON-CSF SCPI 19, avenue de Messine, F-75008 Paris(FR)**
Inventeur: **Marty, Michel, THOMSON-CSF SCPI 19, avenue de Messine, F-75008 Paris(FR)**

(74) Mandataire: **Rinuy, Santarelli, 14, avenue de la Grande Armée, F-75017 Paris(FR)**

## Description

La présente invention concerne un nouveau procédé de fabrication de circuits intégrés utilisant des transistors à effet de champ, soit d'un seul type de canal (en général MOS à canal N) soit de types complémentaires (technologie CMOS) utilisant des transistors MOS à canal N et à canal P).

On cherche à faire des circuits de plus en plus petits et incorporant le plus grand nombre possible d'éléments. Ceci implique que l'on réalise des structures d'éléments individuels aussi petits que possible et que l'on utilise des technologies d'intégration avec autoalignement des motifs formés successivement sur les pastilles de circuit.

En particulier, une technique maintenant très utilisée consiste à utiliser des grilles de transistors MOS en silicium polycristallin dopé, gravées avant l'implantation des régions de source et de drain des transistors : la grille sert de masque lors de l'implantation ; la source et le drain sont donc autoalignées par rapport aux bords de la grille.

On se sert aussi de couches de silicium polycristallin pour réaliser des électrodes de source et de drain en contact avec le silicium monocristallin du substrat et pour réaliser des interconnexions entre transistors. Outre l'aptitude du silicium polycristallin dopé (du même type de conductivité que la source et le drain) à servir de masque lors de l'implantation des régions de source et de drain, ce matériau présente l'avantage de réaliser un bon contact ohmique avec les régions de source et de drain.

Malheureusement, même si le silicium polycristallin est fortement dopé, sa conductivité est relativement limitée et on éprouve le besoin de l'augmenter (puisqu'il sert à réaliser des connexions conductrices entre éléments); pour cela on forme une couche de siliciure métallique (siliciure de molybdène, tungstène, titane, tantale par exemple) à la surface supérieure du silicium polycristallin.

Cette couche est formée en déposant au-dessus du silicium polycristallin une couche métallique (par pulvérisation cathodique à partir d'une cible du métal considéré) et en formant par recuit un composé (siliciure) avec le silicium polycristallin situé au-dessous. On peut aussi déposer directement un siliciure par pulvérisation cathodique d'une cible de siliciure métallique frittée. Ceci dépend du métal considéré. Du document EP-A 0 101 000 est connu un dispositif semiconducteur comportant des transistors MOS et bipolaires où les contacts d'émetteur et de collecteur ainsi que les grilles sont réalisés dans une couche uniforme diposée et photogravée de silicide de métal réfractaire. Cette couche sert de masque pour des implantations ultérieures de soudes et de drains autoalignés.

La présente invention propose un nouveau procédé de fabrication n'utilisant pas de silicium polycristallin pour la formation des grilles, électrodes de source et drain et interconnexions des transistors MOS du circuit.

Ce procédé comprend les étapes successives suivantes (pour les étapes a) – d) voir par exemple US-A 4 280 271):

a) formation, sur un substrat de silicium monocristallin d'un premier type de conductivité, dans une zone active, d'une couche mince isolante constituant l'isolant de grille d'un transistor à effet de champ,

b) dépôt et photogravure d'une résine de masquage, le motif de résine protégeant une zone recouvrant l'emplacement de la grille à réaliser et débordant légèrement de part et d'autre de celui-ci,

c) implantation ionique d'impuretés d'un second type de conductivité opposé au premier, pour définir des portions de régions de source et drain,

d) élimination de la résine, et il est plus particulièrement caractérisé par les opérations suivantes:

e) photogravure de la couche mince isolante pour dénuder le silicium monocristallin dans des zones servant à établir des contacts pour des électrodes de source et de drain,

f) dépôt d'une couche uniforme d'un siliciure métallique sur la totalité du substrat, le siliciure reposant sur la couche mince isolante là où elle est présente et venant en contact direct avec le silicium monocristallin dans les zones dénudées,

g) photogravure du siliciure pour définir une grille, une électrode de source, une électrode de drain, et des interconnexions,

h) implantation ionique d'impuretés pour définir les extrémités des régions de source et de drain, autoalignées avec la grille, le siliciure servant de masque d'implantation,

i) recuit du substrat.

Par conséquent, dans ce procédé on réalise des électrodes de grille de source et de drain toutes constituées par une couche unique de siliciure métallique, de préférence du siliciure de tantale; ce siliciure est directement en contact avec le silicium monocristallin dans les régions de source et de drain. Il est directement en contact avec l'isolant de grille au-dessus du canal du transistor. Les extrémités des régions de source et de drain sont autoalignées puisque le siliciure sert de masque lors de l'étape h.

Dans une adaptation à une technologie CMOS on réalise une structure originale dans laquelle les transistors à canal N comme les transistors à canal P sont réalisés comme il est indiqué ci-dessus, c'est-à-dire avec des électrodes toutes constituées par une couche unique de siliciure métallique mais les régions de source et de drain des transistors contenus dans des caissons de type de conductivité opposé au substrat sont très peu dopées par rapport aux régions de source et drain des transistors non contenus dans des caissons de manière à établir un contact de type Schottky avec le siliciure permettant de réduire le risque de "latch-up".

Cette structure est possible si on constate qu'un contact de type Schottky peut exister entre l'électrode de source (ou de drain) et le silicium monocristallin en conservant de bonnes capacités de conduction du transistor.

Cette structure CMOS présente l'avantage d'être beaucoup moins sensible au déclenchement de thyristors parasites qu'on rencontre souvent dans les structures CMOS; ce phénomène de déclenchement est connu sous le nom anglais de "latch-up" et il résulte de l'existence de successions de régions voisines de types de conductivité alternés; par exemple un déclenchement peut exister à cause de la juxtaposition des régions suivantes: source N+ d'un MOS à canal N, substrat de type P, caisson de type N, source P+ d'un transistor MOS à canal P formé dans le caisson.

Le très faible dopage des régions de source et drain dans les caissons, rendu possible par la présence de siliciure métallique, permet de réduire considérablement le risque de "latch-up". Des structures CMOS où des régions source et drain p+ sont remplacées par des barrières Schottky (PtSi) afin d'éliminer le "latch-up" sont connues de l'article de M. Sugino et al, publié dans IEEE Transactions on Electron Devices ED–30, n° 2, février 1983, pages 110–118.

Le procédé de fabrication de la structure CMOS est analogue à celui qui a été défini ci-dessus pour un seul type de canal. Mais les étapes d'implantation d'impuretés se font séparément pour les deux types de transistors, les transistors à canal N étant complètement masqués par une résine pendant qu'on effectue une opération d'implantation sur les transistors à canal P et réciproquement.

Les gravures d'isolant mince et de siliciure métallique se font au contraire simultanément pour les deux types de transistors.

D'autres caractéristiques et avantages de l'invention apparaîtront à la lecture de la description détaillée qui suit et qui est faite en référence aux dessins annexés dans lesquels:

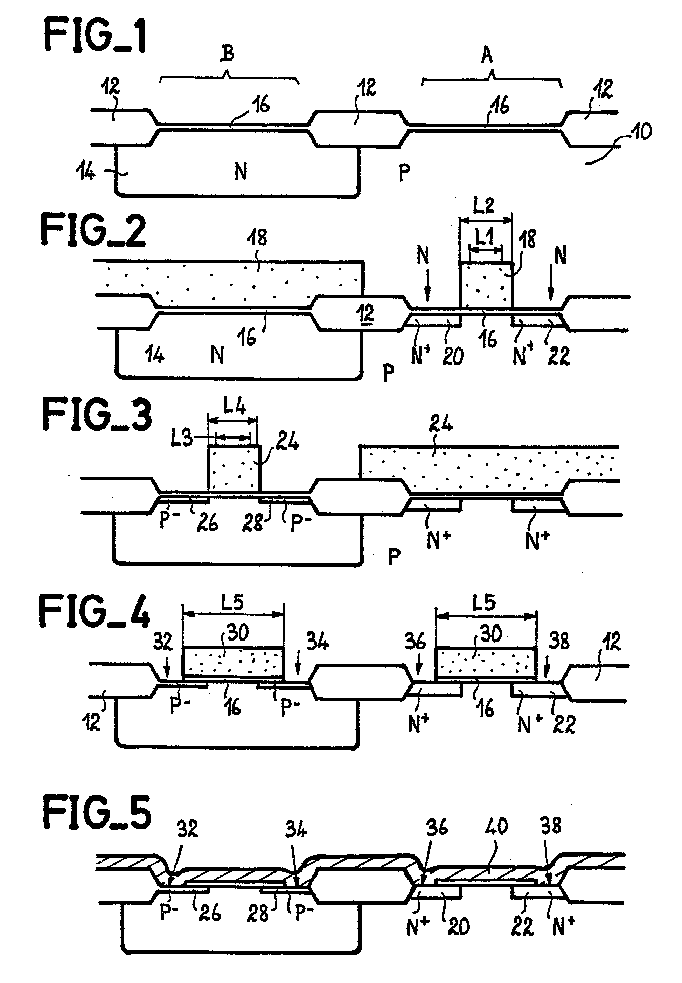

– les figures 1 à 9 représentent les étapes successives du procédé selon l'invention appliquées à une structure CMOS.

On forme d'abord, dans un substrat de silicium monocristallin 10 d'un premier type de conductivité, par exemple P, des caissons de type opposé (N). Les caissons contiendront les transistors à canal P; le substrat contiendra les transistors à canal N.

On définit des zones actives de silicium monocristallin correspondant chacune à un transistor, ces zones étant entourées par des murs d'oxyde épais 12.

Sur la figure 1, une zone active A (partie droite) correspond à un transistor à canal N formé directement dans le substrat et une zone B (partie gauche) correspond à un transistor à canal P formé dans un caisson 14. Les caissons seraient supprimés si on faisait uniquement des transistors à canal N.

Le caisson et les murs sont formés de manière classique par diffusion localisée d'impuretés de type N puis oxydation localisée. Des étapes non représentées peuvent être prévues en outre, comme par exemple une implantation de couches anti-inversion sous l'oxyde épais, ou encore des implantations d'ajustement de seuil des transistors.

On forme ensuite une couche isolante mince 16 sur la surface des zones actives A et B, de préférence par oxydation thermique du silicium monocristallin. Cette couche 16 constituera l'isolant de grille des transistors MOS et peut avoir une épaisseur de quelques centaines d'angströms, par exemple 200 angströms ou même moins.

La figure 1 représente le substrat à ce stade de la fabrication.

On dépose alors une couche de résine photosensible de masquage 18 que l'on grave selon un motif tel que la résine subsiste au-dessus de la totalité des caissons (zone active B) et subsiste audessus d'une partie seulement de la zone active A.

Plus précisément, dans la zone A, le motif de résine 18 recouvre une bande traversant toute la zone A sur une largeur très légèrement supérieure à la future largeur de grille des transistors (on appellera ici largeur de grille la dimension prise dans le sens de la longueur du canal entre source et drain). On a désigné par $L_1$ la future largeur de grille sur la figure 2, et par $L_2$ la largeur du motif de résine. La différence entre $L_1$ et $L_2$ est choisie en principe égale à la valeur minimale compatible avec les tolérances de positionnement de masques successifs de manière que le motif de résine 18 recouvre avec certitude la totalité de l'emplacement de la future grille.

La résine 18 est déposée avec une épaisseur suffisante pour servir de masque efficace lors d'une implantation ionique.

Il peut notamment s'agir d'une résine multicouche (résine de base épaisse recuite à 200°C environ, surmontée d'une couche mince minérale telle que de l'oxyde de silicium ou de titane, elle même surmontée d'une couche mince de résine photosensible).

On effectuera alors une implantation ionique d'impuretés de type N (phosphore) qui pénètrent dans le silicium monocristallin là où il n'est pas protégé par la résine.

On forme ainsi une portion de région de source 20 et une portion de région de drain 22 (non autoalignées par rapport à la grille) des transistors à canal N.

On élimine alors la résine et on répète un processus de masquage similaire du côté de la zone active B, et une implantation d'impuretés de type P : pour cela on dépose une résine 24, on la grave en masquant complètement la zone active A et une bande de largeur $L_4$ au milieu de la zone B, la largeur $L_4$ étant choisie légèrement supérieure à la largeur $L_3$ de la future grille (figure 3).

L'implantation de type P qui suit la photogravure de la résine 24 est effectuée à faible profondeur et faible dose, de sorte qu'on ne constitue pas véritablement des portions de région de source et drain des transistors MOS à canal P, mais on forme des zones superficielles 26 et 28 faiblement dopées de type P (le symbole P⁻ sur la figure indique qu'il s'agit d'un faible dopage).

A titre d'exemple, l'implantation de type P (figure 3) peut se faire avec une dose de bore de 1 à $5 \times 10^{13}$ atomes/cm² et une énergie de 30 keV, alors que l'implantation de type N (figure 2) peut se faire avec une dose de phosphore de 1 à $5 \times 10^{15}$ atomes/cm² et une énergie de 100 keV.

Les étape des figures 2 et 3 peuvent être interverties. L'étape de la figure 3 serait supprimée si on désirait faire uniquement des transistors à canal N.

On dépose ensuite à nouveau une résine photosensible 30 qui n'a pas besoin d'être aussi épaisse que les résines 18 et 24 car elle ne servira pas de masque d'implantation, mais qui doit résister à des produits d'attaque de la couche isolante mince 16 (figure 4).

La résine 30 est photogravée pour laisser subsister un motif de bandes de largeur L5 recouvrant largement, dans les zones actives, les régions qui n'ont pas été implantées, c'est-à-dire les régions en dehors des zones 20, 22, et 26, 28. La résine est éliminée ailleurs, et notamment au-dessus des extrémités (du côté des murs d'oxyde épais 12) des régions 20, 22, 26, 28.

On effectue alors une attaque de la couche isolante mince 16 pour l'éliminer dans les zones où elle n'est pas recouverte par la résine, c'est-à-dire :
- dans des zones 32 et 34 constituant des régions de contact pour des électrodes de source et de drain de transistors à canal P,
- dans des zones 36 et 38 constituant des régions de contact pour des électrodes de source et de drain de transistors à canal N.

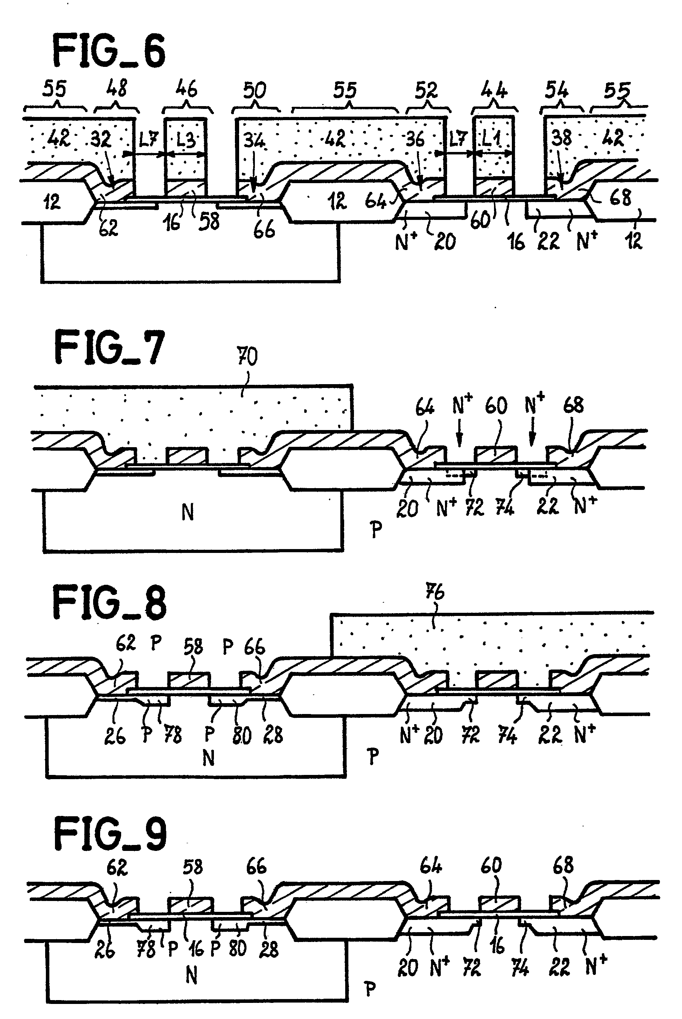

On élimine la résine 30 et on dépose une couche uniforme 40 de siliciure métallique, de préférence du siliciure de tantale, déposé par pulvérisation cathodique à partir d'une cible de siliciure de tantale frittée (figure 5).

Cette couche 40 vient en contact avec la couche isolante mince 16 là où elle est présente dans le zones actives (largeur L5) et vient en contact direct avec le silicium monocristallin dans les zones 32, 34, 36, 38 là où l'oxyde de silicium mince a été éliminé.

On dépose à nouveau une couche de résine photosensible 42 (qui peut être une résine tricouche) qui doit avoir la propriété de résister, une fois développée, aux produits d'attaque du siliciure métallique de la couche 40 (figure 6).

On grave la résine 42 pour définir des motifs d'électrodes de grille, d'électrodes de source et de drain et d'interconnexions en siliciure de tantale.

Ainsi, la résine 42 définit, après photogravure :
- un motif 44 de largeur L1 au-dessus des emplacements de grilles de transistors à canal N,
- un motif 46 de largeur L3 au-dessus des emplacement de grilles de transistors à canal P,
- un motif 48 pour une électrode de source de transistors à canal P, au-dessus de la zone de contact 32 et débordant légèrement (par sécurité) au-dessus de l'oxyde mince 16,
- un motif 50 pour une électrode de drain de transistor à canal P, au-dessus de la zone de contact 34 et débordant légèrement (par sécurité) au-dessus de l'oxyde mince 16,
- un motif 52 pour une électrode de source de transistor à canal N, au-dessus de la zone de contact 36 et débordant légèrement (par sécurité) au-dessus de l'oxyde mince 16,
- un motif 54 pour une électrode de drain de transistor à canal N, au-dessus de la zone de contact 38 et débordant légèrement (par sécurité) au-dessus de l'oxyde mince 16,
- des motifs 55 pour des interconnexions en siliciure de tantale au-dessus des régions d'oxyde épais 12.

La résine est éliminée entre le motif 46 et les motifs 48 et 50 et de même entre le motif 44 et les motifs 52 et 54, dans des intervalles de largeur aussi étroite que possible, par exemple une largeur L7. On notera que la largeur L5 définie à l'étape de la figure 4 doit être au moins égale à L1 + 2L7.

Ayant photogravé la résine, on procède à l'attaque du siliciure de tantale par une gravure ionique réactive utilisant un plasma à mélange fluoré et chloré. On arrête la gravure lorsque la couche mince isolante 16 est dénudée.

On obtient donc un motif de grilles 58 et 60, d'électrodes de source 62, 64 et d'électrodes de drain 66, 68.

On élimine la résine 42 et on dépose une nouvelle couche de résine 70 que l'on grave de manière à masquer complètement les zones actives B correspondant aux transistors à canal P, les zones A étant complètement découvertes (figure 7).

On effectue une implantation ionique d'impuretés de type N (phosphore), par exemple avec une dose de $1 \times 10^{14}$ atomes/cm² en utilisant le siliciure de tantale comme masque d'implantation là où il est présent; on complète ainsi les régions de source et drain 20 et 22 des transistors à canal N par des régions d'extrémité (côté grille) 72 et 74 auto-alignées par rapport à la grille 60.

De la même manière, après avoir éliminé la résine 70, on dépose une nouvelle couche de résine 76 que l'on grave de manière à masquer totalement les zones actives A correspondant aux transistors à canal N, les zones B étant complètement découvertes (figure 8).

On effectue une implantation ionique d'impuretés de type P, par exemple avec une dose de 0,1 à $1 \times 10^{15}$ atomes/cm² en utilisant le siliciure de tantale comme masque d'implantation là où il est présent ; on forme ainsi des régions de source et drain proprement dites, 78 et 80, des transistors à canal P, auto-alignées par rapport à la grille 58. Ces régions sont nettement plus dopées que les régions 26 et 28 formées précédemment (figure 3).

Les opérations de masquage et implantation définies à propos des figures 7 et 8 peuvent être interverties, les opérations correspondant à la figure 8 étant supprimées si on ne réalise que des transistors à canal N.

On aboutit à la structure finale représentée à la figure 9, après avoir éliminé la résine 76 et après avoir effectué un recuit thermique pour corriger les défauts de structure cristallines introduits par les diverses opérations d'implantation. Sur cette structure, on voit que toutes les électrodes de grille, de source et de drain sont constituées par des portions d'une même couche de siliciure de tantale directement en contact avec le silicium monocristallin (pour les électrodes de source et drain) ou avec l'oxyde mince 16 (pour les électrodes de grille) ; du côté des transistors formés dans un caisson, le silicium monocristallin en contact avec le siliciure est très peu dopé comparativement au silicium en contact avec le siliciure en dehors des caissons.

Un contact de type Schottky (métal/semiconducteur faiblement dopé) est donc établi entre électrode de source ou drain et silicium monocristallin pour les transistors en caisson. Il y a ainsi beaucoup moins de risque de "latch-up" entre deux transistors voisins.

**Revendications**

1. Procédé de fabrication d'un circuit intégré à transistors MOS; comprenant les opérations suivantes:

a) formation, sur un substrat de silicium monocristallin (10) d'un premier type de conductivité, dans une zone active, d'une couche mince isolante (16) constituant l'isolant de grille d'un transistor à effet de champ,

b) dépôt et photogravure d'une résine de masquage (18), le motif de résine protégeant une zone recouvrant l'emplacement de la grille à réaliser et débordant légèrement de part et d'autre de celuici,

c) implantation ionique d'impuretés d'un second type de conductivité opposé au premier, pour définir des portions (20 et 22) de régions de source et drain,

d) élimination de la résine, caractérisé par les opérations suivantes:

e) photogravure de la couche mince isolante (16) pour dénuder le silicium monocristallin dans des zones (36, 38) servant à établir des contacts pour des électrodes de source et de drain,

f) dépôt d'une couche uniforme d'un siliciure métallique (40) sur la totalité du substrat, le siliciure reposant sur la couche mince isolante là où il est présent et venant en contact direct avec le silicium monocristallin dans les zones dénudées,

g) photogravure du siliciure pour définir une grille (60), une électrode de source (64), une électrode de drain (68), et des interconnexions,

h) implantation ionique d'impuretés pour définir les extrémités (72, 74) des régions de source et de drain, auto-alignées avec la grille (60), le siliciure servant de masque d'implantation,

i) recuit du substrat.

2. Procédé de fabrication d'un circuit intégré à transistor MOS selon la revendication 1, caractérisé en ce que, préalablement à l'opération a) on forme dans le substrat des caissons de type de conductivité opposé au substrat pour y former des transistors de type de canal opposé à celui des transistors formés en dehors des caissons, on effectue séparément pour les transistors des caissons et pour les autres les opérations b, c, d, et h, la dose d'impuretés et l'énergie de l'implantation ionique de l'opération c) étant beaucoup plus faible pour les transistors formés dans les caissons que pour les transistors formés directement dans le substrat.

3. Structure de transistors CMOS comprenant des transistors formés dans un substrat (10) de silicium monocristallin d'un premier type de conductivité et des transistors formés dans des caissons (14) de type opposé, caractérisé en ce que les électrodes de source (62, 64), de drain (66, 68) et de grille (58, 60) des transistors sont formés par des portions d'une même couche déposée d'un siliciure métallique (40) directement en contact avec le silicium monocristallin et avec une couche isolante mince (16) sous la grille, le siliciure étant en contact Schottky avec une partie très peu dopée des regions (26, 28) source et drain des transistors formés dans les caissons et en contact avec une partie des régions source (20) et drain (22) beaucoup plus dopées des transistors formés en dehors des caissons.

**Patentansprüche**

1. Verfahren zur Herstellung einer integrierten Schaltung mit MOS-Transistoren, das folgende Schritte umfaßt:

a) Bildung für die Gateisolierung eines Feldeffekttransistors bildenden dünnen Isolierschicht (16) auf einem Substrat (10) aus monokristallinem Silizium von einem ersten Leitfähigkeitstyp in einer aktiven Zone,

b) Aufbringen und Photogravur eines Maskierungsharzes (18), wobei das Harzmuster eine die Stelle des herzustellenden Gates bedeckende Zone schützt und auf beiden Seiten geringfügig von ihr vorsteht,

c) Ionenimplantation von Verunreinigungen des zweiten, dem ersten entgegengesetzten Leitfähigkeitstyps, um Abschnitte (20 und 22) von Source- und Drain-Gebieten zu definieren,

d) Entfernung des Harzes, gekennzeichnet durch folgende Schritte:

e) Photogravur der dünnen Isolierschicht (16), um das monokristalline Silizium in Zonen (36, 38) freizulegen, die zur Anbringung der Kontakte für die Source- und Drain-Elektroden dienen,

f) Aufbringen einer gleichmäßigen Schicht aus einer Siliziummetallverbindung (40) auf dem gesamten Substrat, wobei die Siliziummetallverbindung auf der dünnen Isolierschicht dort aufliegt, wo diese vorhanden ist, und in den freigelegten Zonen in direkten Kontakt mit dem monokristallinen Silizium kommt,

g) Photogravur der Siliziummetallverbindung, um ein Gate (60), eine Source-Elektrode (64), eine Drain-Elektrode (68) und Verbindungen zu definieren,

h) Ionenimplantation von Verunreinigungen, um die Enden (72, 74) der Source- und Drain-Gebiete unter Autoregistrierung relativ zum Gate (60) zu definieren, wobei die Siliziummetallverbindung als Implantationsmaske dient,

i) Ausglühen des Substrats.

2. Verfahren zur Herstellung einer integrierten Schaltung mit MOS-Transistor nach Anspruch 1, dadurch gekennzeichnet, daß vor dem Schritt a) im Substrat kastenförmige Gebiete mit dem Leitfähigkeitstyp des Substrats entgegengesetzten Leitfähigkeitstyp gebildet werden, um dort Transistoren von jenem Kanaltyp zu bilden, der dem der außerhalb der kastenförmigen Gebilde gebildeten Transistoren entgegengesetzt ist, daß für die Transistoren der kastenförmigen Gebiete und für die anderen die Schritte b, c, d und h gesondert durchgeführt werden, wobei die Verunreinigungsdosis und die Ionenimplantationsenergie im Schritt c) für die in den kastenförmigen Gebieten gebildeten Transistoren viel geringer ist als für die direkt im Substrat gebildeten Transistoren.

3. CMOS-Transistorstruktur mit in einem Substrat (10) aus monokristallinem Silizium von einem ersten Leitfähigkeitstyp gebildeten Transistoren und in kastenförmigen Gebieten vom entgegengesetzten Typ (14) gebildeten Transistoren, dadurch gekennzeichnet, daß die Source-Elektroden (62, 64), die Drain-Elektroden (66, 68) und die Gateelektroden (58, 60) der Transistoren durch Abschnitte ein- und derselben in direktem Kontakt mit dem monokristallinen Silizium und mit einer dünnen Isolierschicht (16) unter dem Gate stehenden abgelagerten Schicht einer Siliziummetallverbindung (40) gebildet sind, wobei die Siliziummetallverbindung einen Schottky-Kontakt mit einem sehr gering dotierten Teil der Source- und Drain-Gebiete (26, 28) der in den kastenförmigen Gebieten gebildeten Transistoren und einen Kontakt mit einem Teil der viel stärker dotierten Source- und Drain-Zonen (20, 22) der außerhalb der kastenförmigen Zonen gebildeten Transistoren bildet.

## Claims

A process for manufacture of an integrated circuit with MOS transistors, comprising the following operations:

a) formation, in an active zone, on a monocrystalline silicon substrate (10) having a first type of conductivity of a thin insulating layer (16) constituting the gate insulator of a field effect transistor,

b) deposition and photogravure of a masking resin (18), the pattern of the resin protecting a zone covering the site of the gate to be made and projecting slightly on each side of the latter,

c) ionic implantation of impurities having a second type of conductivity opposite to the first to define portions (20 and 22) of regions of source and drain,

d) removal of the resin, characterized by the following operations:

e) photogravure of the thin insulating layer (16) to uncover the monocrystalline silicon in the zones (36, 38) serving to establish contacts for the source and drain electrodes,

f) deposition of a uniform layer of a metallic silicide (40) over the entire substrate, the silicide resting on the insulating thin layer where this is present and coming into direct contact with the monocrystalline silicon in the uncovered zones,

g) photogravure of the silicide to define a gate (60), a source electrode (64), a drain electrode (68) and interconnections,

h) implantation of ionic impurities to define the ends (72, 74) of the regions of source and drain, auto-aligned with the gate (60), the silicide acting as an implantation mask, i) reheating of the substrate.

2. A process for manufacture of an integrated circuit with MOS transistors according to Claim 1, characterized in that prior to operation a) wells of the kind having a conductivity opposite to that of the substrate are formed in the substrate, to form transistors there with a channel type opposite to that of the transistors formed outside the wells, the operations b, c, d, and h are performed separately for the transistors in the wells and for the others, the dose of impurities and the energy of the ionic implantation in operation c) being much less in the case of the transistors formed in the wells than for the transistors formed directly in the substrate.

3. CMOS transistor structures comprising transistors formed in a substrate (10) of monocrystalline silicon having a first type of conductivity and transistors formed in wells (14) having the opposite type, characterized in that the source electrodes (62, 64), the drain electrodes (66, 68) and the gate electrodes (58, 60) of the transistors are formed by portions of the same layer of a metallic silicide (40) deposited directly in contact with the monocrystalline silicon and with a thin insulating layer (16) below the gate, the silicide being in Schottky contact with a very lightly doped part of the source and drain regions (26, 28) of the transistors formed in the wells and in contact with a much more highly doped part of the source (20) and drain (22) regions of the transistors formed outside the wells.

FIG_1

FIG_2

FIG_3

FIG_4

FIG_5

FIG_6

FIG_7

FIG_8

FIG_9